# EUROPEAN PATENT APPLICATION

(11) **EP 2 168 643 A1**
(43) Date of publication of application: **31.03.2010**
(21) Application number: 08165434.5
(22) Date of filing: 29.09.2008
(51) Int. Cl.: B01B 1/00, B05D 7/24

(54) **Evaporator for organic materials**

(71) Applicant: Applied Materials, Inc., Santa Clara, CA 95054 (US)
(72) Inventor: Hein, Stefan, 63825, Blankenbach (DE); Hoffmann, Gerd, 63486, Bruchkoebel (DE)
(74) Representative: Zimmermann & Partner

(57) **Abstract**

An evaporator for vaporizing organic material is described. The evaporator includes a first chamber having a nozzle adapted to be directed to a substrate to be coated; at least one second chamber for vaporizing the organic material; at least one vapour channel for guiding vaporized organic material from the at least one second chamber to the first chamber; wherein the first chamber is adapted to provide vaporized organic material to the nozzle corresponding to a first virtual sublimation surface, and the at least one second chamber being adapted to provide during operation a second sublimation surface area, wherein the second sublimation surface area corresponds to at least 70 percent of the first virtual sublimation surface.

## Description

### TECHNICAL FIELD OF THE INVENTION

Embodiments of the present invention relate to an evaporator for vaporizing organic materials, in particular melamine. Further, the present invention relates to a method for coating a substrate with an organic material, in particular melamine.

### BACKGROUND OF THE INVENTION

Generally, melamine can be evaporated (sublimated). Typically, the material to be vaporized is arranged in a rectangular crucible, in which the material to be vaporized is disposed. The crucible may be placed into a vaporizer tube that may be heated with a heating device or a heating system. The crucible has to be heated to a temperature such that the melamine evaporates. The temperature at which melamine evaporates is about 250 °C to 300 °C. Melamine burns already at a temperature of about 330 °C. Thus, the evaporation rate cannot be significantly increased by varying the temperature of the heating devices. Further, the vaporizer tube has to be adapted to the width of a substrate or web to be coated. Thus, only substrates or webs with a limited width could be used in an efficient process as the crucible or evaporator with a nozzle directly placed adjacent to the substrate or web are adapted to the width of the substrate or web to be coated. Therefore, the evaporators have a length along the width of the substrate of about 1600 mm.

Thus, it is desired to provide an improved vaporizer, in particular a vaporizer of melamine which allows a more uniform or homogenous deposition of melamine. Further, it is desired to provide a vaporizer for melamine which is simple to use and to manufacture, as well as a method for providing a homogenous coating of melamine on a flexible substrate or web, in particular, a substrate or web with a large width.

### SUMMARY OF THE INVENTION

According to one embodiment, an evaporator for vaporizing organic material is provided. The evaporator includes a first chamber having a nozzle adapted to be directed to a substrate to be coated; at least one second chamber for vaporizing the organic material; at least one vapour channel for guiding vaporized organic material from the at least one second chamber to the first chamber; wherein the first chamber is adapted to provide vaporized organic material to the nozzle corresponding to a first virtual sublimation surface, and the one or more chambers of the at least one second chamber being adapted to provide during operation a combined second sublimation surface area, wherein the second sublimation surface area corresponds to at least 70 percent of the first virtual sublimation surface.

According to a further embodiment, a method for coating a substrate with organic material with an evaporator having a first chamber and a second chamber is provided. The method includes sublimating the organic material in a second chamber having a during operation a second sublimation surface area; guiding the sublimated organic material from the second chamber to the first chamber, the first chamber having a nozzle directed to the substrate to deposit the sublimated organic material on the substrate, wherein the first chamber is adapted to provide vaporized organic material to the nozzle corresponding to a first virtual sublimation surface, wherein the second sublimation surface area corresponds to at least 70 percent of the first virtual sublimation surface.

According to yet another embodiment an evaporator for vaporizing melamine is provided including a first chamber having a nozzle adapted to be directed to a substrate to be coated; at least one second chamber for vaporizing the melamine; at least one vapour channel for guiding vaporized melamine from the at least one second chamber to the first chamber; wherein and one or more chambers of the at least one second chamber being adapted to provide during operation a combined second sublimation surface area of about 0,34m² or more,

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Fig. 1 shows a schematic vaporizer assembly;
Fig. 2 shows a further embodiment of the first chamber;
Fig. 3 shows another embodiment of the first chamber;
Fig. 4 shows a further embodiment of the first chamber;
Fig. 5 shows a further embodiment of the second chamber for an evaporation of melamine;
Fig. 6 shows another embodiment of a second chamber for an evaporation of melamine;
Fig. 7 shows another embodiment of a second chamber for an evaporation of melamine; and
Fig. 8 shows a flow chart of a method.

### DETAILED DESCRIPTION OF THE EMBODIMENTS

Reference will now be made in detail to the various embodiments, one or more examples of which are illustrated in the figures. Each example is provided as a means of explanation, and is not meant as a limitation of the invention. Within the following description of the drawings, the same reference numbers refer to the same components. Generally, only the differences with respect to the individual embodiments are described.

Some organic materials, like melamine may be evaporated or sublimated at about 300 °C, in particular between about 210 °C and about 320 °C, at 10⁻² mbar. In a further embodiment, melamine is evaporated at about 250 °C and 310 °C. Melamine to be sublimated burns at a temperature slightly higher than the sublimation temperature. For example, melamine burns at about 330 °C. Therefore, the temperature of the melamine to be evaporated has to be controlled. Typically, as the heat has to be provided in a narrow range of a temperature, the evaporation rate of the evaporator cannot be significantly increased by increasing the evaporation temperature as the melamine is not evaporated but burned at higher temperatures. Thus, to provide a uniform or a homogenous coating of the melamine, the evaporated melamine has to be provided to a nozzle of an evaporator in a substantially uniform manner and/or rate for substrates or webs with a large width.

In the following reference herein is made to melamine. However it is understood that the embodiments may also apply to other organic materials having a relatively small range in which evaporation is possible and for which the material can be burned at a temperature slightly above the desired evaporation temperature, e.g. only 70°C, in particular only 50°C, or even only at bout 30°Cover the desired evaporation temperature. Typically, the embodiments described herein may also be used for the deposition of organic material in the production of Organic Light-Emitting Diodes (OLEDs).

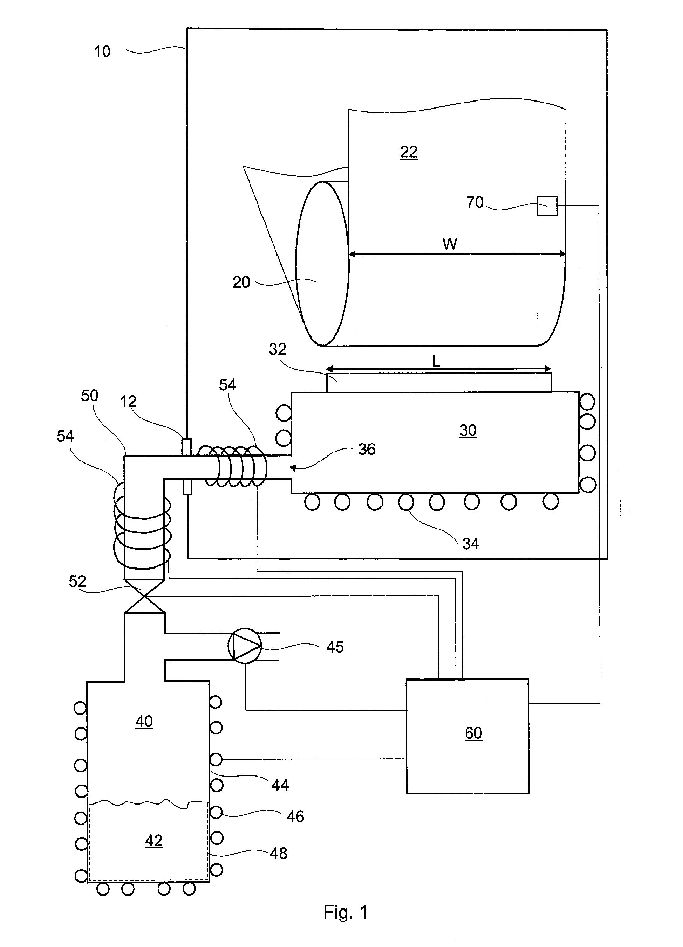

Fig. 1 shows a schematic drawing illustrating embodiments of a vaporizer assembly. The vaporizer assembly includes a housing 10. The housing interior has a pressure of about 5⁻³ mbar to about 1⁻², typically about 10⁻² mbar. A web or substrate 22 to be treated is guided in a conveying direction through the housing 10. The web or substrate 22 has, orthogonal to the conveying direction, a predetermined width W. According to one embodiment which can be combined with other embodiments herein, the width of the substrate may range in a specific embodiment between about 1,2 m and 4m, typically between about 2 m and 3,5 m . In the housing 10, the substrate 22 is coated with melamine, or other materials. In the housing 10, a rotating drum 20 is located that guides the substrate 22. The drum 20 is provided for forming a support of the substrate 22 passing in a front of a nozzle 32 of a first chamber 30.

The nozzle 32 ejects evaporated or sublimated melamine to be deposited on the substrate 22. The first chamber 30 provides the sublimated melamine to the nozzle 32. Thus, evaporated melamine in the first chamber 30 passes through the nozzle 32 and is deposited on the substrate or web 22. The drum 20 may, in a typical embodiment, be cooled such that the sublimated melamine desublimates on the substrate 22 in a short period of time. Thus the heat load on the flexible substrate is reduced.

According to some embodiments, which can be combined with other embodiments described herein, the first chamber 30 with nozzle 32 is arranged below or opposing the drum 20 supporting the substrate 22. Then, the nozzle 32 of the first chamber 32 is directed upwards. In a further embodiment, the nozzle 32 may be arranged in a lateral wall of the first chamber 30, in particular if the drum 20 supporting the substrate 22 is arranged horizontally spaced apart from the nozzle 32, and the discharge of sublimated melamine of the nozzle 32 towards the substrate 22 is directed substantially horizontal.

The nozzle 32 has, in some embodiments, a slit opening having its longitudinal extension about parallel to the rotating axis of the drum and/or the width of the substrate 22. In other embodiments, the nozzle 32 may also have several openings arranged to cover a substantial part of the width of the substrate 22, in particular the whole width of the substrate 22. According to yet further embodiments, which can be combined with any of the embodiments described herein, the slit opening or the openings may be closed or opened by a shutter that is not shown in the drawing.

In typical embodiments, which may be combined with other embodiments described herein, a second chamber 40 is disposed outside the housing 10. The second chamber 40 may be filled, at least partially, with melamine 42. The second chamber 40 has a chamber wall 44. Heating devices 46 are disposed on the outer surface of the chamber wall 44 of the second chamber 40. When the heating devices are activated, the heat of the heating devices 46 passes through the wall 44 of the second chamber 40 and heats the melamine 42 in the second chamber 40. When the melamine is heated by the heating devices 46 to the sublimation temperature, in particular of about 250 °C to 320 °C, typically of about 300 °C, the melamine 42 starts to sublimate, typically at the chamber walls 44. A sublimation surface 48 (dotted line in Fig. 1) may be defined as the area of the chamber wall 44, which is covered by the melamine 42 and is heated to the sublimation temperature. Therefore, the sublimation surface 48 varies with the quantity of melamine 42 in the second chamber 40, and the quantity of sublimated melamine varies as a function of the time.

When the melamine 42 evaporates, it passes through a channel 50 providing a fluid connection between the second chamber 40 and the first chamber 30. According to one embodiment, which may be combined with other embodiments described herein, the channel 50 may include a valve 52 for regulating the flow of vaporized or sublimated melamine from the second chamber 40 to the first chamber 30. The valve 52 may, for example, be a butterfly valve. Other suitable valves may be used for that purpose in other embodiments. In Fig. 1, the channel 50 passes through an opening 12 of the housing 10. The housing 10 may be sealed at the opening 12, such that according to some embodiments the second chamber 40, wherein the melamine 42 is evaporated, may be placed in a room with a normal atmospheric pressure. Thus, the second chamber 40 can be refilled with melamine without changing the sub-atmospheric pressure in the housing 10. For that purpose, for example, the valve 52 may be closed and a further opening (not shown) may be opened for refilling the second chamber 40 with melamine 42.

According to some embodiments, which may be combined with other embodiments described herein the channel 50 may have smaller a cross section than the first chamber.

According to some embodiments, which can be combined with other embodiments described herein, the second chamber 40 may be in fluidal connection with a vacuum pump 45. As long as the valve 52 is in a closed position, i.e. that no fluidal exchange is permitted between the first chamber 30 and the second chamber 40, the vacuum pump 45 may be activated to create a vacuum in the second chamber 40 with the same pressure as in the housing 10. Then, the valve 52 may be opened. Additionally or alternatively a bypass to the lower pressure in housing 10 may be provided for reducing the pressure in the second chamber 40 at or providing a reduced pressure in the second chamber 40 when valve 52 is closed.

According to some embodiments, which can be combined with other embodiments described herein, heating devices 34, 54 may be disposed at least around one of the channel 50, the valve 52, and the first chamber 30. If the channel 50 and the first chamber 30 are heated by the heating elements 34, 54, the sublimated melamine may not desublimate or condense on the walls of the channel 50, valve 52 and/or the first chamber 30. For the same purpose, in one embodiment that may be combined with other embodiments, the nozzle 32 and the valve 52 may include at least one heating device or several heating devices. In an embodiment, the valve 52 may be passively heated, in particular by the heating devices 54 used for heating the channel 50.

The vaporizer assembly shown in Fig. 1 further may include a controller 60 for controlling the deposition process of the melamine on the substrate 22. For that purpose, the heating devices 34, 46 and/or 54 are controlled by the controller 60. According to some embodiments, which can be combined with other embodiments described herein, a sensor 70 is arranged to measure the thickness of the melamine coating on the substrate 22 and to provide the results of the measurement to the controller 60. The thickness of the melamine coating on the substrate 22 may be measured along the complete width W or a portion of the width W of the substrate 22. For example two or more sensors 70 may be used for measuring the thickness along the width of the substrate 22. According to one embodiment, which may be combined with other embodiments described herein, the controller may be adapted to control an actuator for closing and opening the valve 52. Thus, the melamine 42 to be sublimated and the sublimated melamine passing through the channel 50 can be accurately controlled to provide a homogenous coating on the web or substrate 22. In particular, the valve 52 may be regulated to provide a constant flow of sublimated melamine from the second chamber 40 to the first chamber 30. The flow may depend on the width of the substrate, the desired thickness of the coating on the substrate 22 and/or the length L of the nozzle 32 of the first chamber 30. In a further embodiment, the shutter for opening and closing the nozzle 32 is controlled by the controller 60. In some embodiments, which may be combined with other embodiments described herein, a closed loop control may be provided, using the sensor 70 for measuring the thickness of the melamine coating on the substrate 22 and the heating devices 34, 46, 54 and/or the valve 52 for regulating the flow of melamine from the first chamber to the second chamber, and then to the nozzle 32.

According to some embodiments, which can be combined with other embodiments described herein, the dimensions of the first chamber 30 and the second chamber 40 are defined with respect to each other. Generally, for the many known apparatuses, the first chamber 30 would be used to evaporate the melamine. Accordingly, the surface provided as if the melamine would be evaporated in the first chamber 30 is referred to as the corresponding or virtual evaporation surface. The first chamber 30, which is disposed in the housing 10, provides a specific quantity of evaporated melamine to the nozzle 32 for the deposition on the substrate 22, wherein the melamine has passed from the second chamber 40 through the channel 50 and an opening 36 in a sidewall of the first chamber 30 to the first chamber 30. The evaporated melamine provided to the nozzle 32 of the first chamber 30 corresponds to a specific sublimation surface. The virtual sublimation surface of the first chamber 30 depends on the length L of the nozzle 32 that correlates substantially with the width W of substrate or web to be coated with melamine. To provide a predetermined thickness of the coating on the substrate 22, the corresponding sublimation surface of the first chamber 30 depends on the evaporated melamine per length L of the nozzle 32. For example, if the corresponding virtual evaporation surface of the first chamber 30 has a length corresponding to the length L of the nozzle 32, the corresponding sublimation surface of the first chamber 30 may have a width of 170 mm.

According to embodiments of the invention, as for example shown in the vaporizer assembly 1 of Fig. 1, the sublimated melamine is produced in the second chamber 40. The second chamber 40 may therefore be adapted to the corresponding sublimation surface of the first chamber 30. For example, the second chamber 30 may have a sublimation surface of more than 70 percent of the corresponding virtual sublimation surface of the first chamber 30. In a further embodiment, the second chamber may have a sublimation surface of more than 90 percent of the corresponding sublimation surface of the first chamber. In a typical embodiment, the sublimation surface of the second chamber may exceed the corresponding sublimation surface of the first chamber. The thickness of the web or substrate to be coated may, therefore, be accurately controlled, as the flow and/or quantity of the melamine passing through the channel 50 may be controlled by the valve 52.

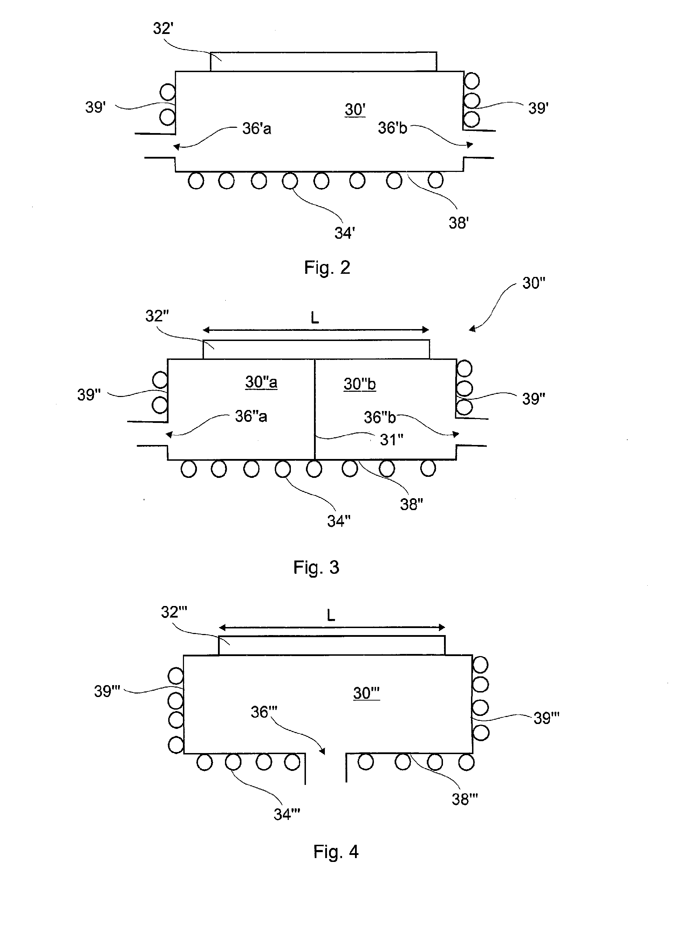

In the following, several embodiments of the first chamber are explained with reference to the drawings of Figs. 2, 3 and 4. These embodiments may be used as alternative or additional modifications of the vaporizer assemblies described herein.

Fig. 2 shows an embodiment of the first chamber 30'. The chamber has nozzle 32' arranged below or opposing the drum 20 transporting the substrate 22, as shown in Fig. 1. The first chamber 30' has a bottom wall 38' opposite the nozzle 32' and side walls 39'. In contrast to the first chamber 30 shown in Fig. 1, the first chamber 30' shown in Fig. 2 has not only one opening 36 but several openings 36'a, 36'b in the side walls 39'. In Fig. 2, only two openings 36'a, 36'b are shown. However, in further embodiments, which can be combined with other embodiments described herein, three or more openings may be arranged in the side walls 39'. The openings 36'a, 36'b are in fluidal connection to the channel 50 and, therefore, to the second chamber 40. Thus, the sublimated melamine provided by the second chamber 40 may enter the first chamber 30 from several directions, and may therefore enhance the uniformity of the deposited melamine along the width W of the substrate 22. According to some embodiments, which can be combined with other embodiments described herein, a corresponding valve for regulating the flow into the first chamber through the respective opening may be provided for each of the openings 36'a, 36'b.

Fig. 3 shows another embodiment of the first chamber 30". The first chamber 30" of Fig. 3 corresponds substantially to the first chamber 30' of Fig. 3. However, the first chamber 30" of Fig. 3 has two sub chambers 30"a, 30"b that are separated by a separation wall 31". The separation wall extends from the bottom 38" of the first chamber 30" to the nozzle 32". Each sub chamber 30"a, 30"b of the first chamber 30" has at least one opening 36'a, 36'b that is in fluidal connection with the channel 50 and, therefore, the second chamber 40. A corresponding valve (not shown) for regulating the flow into the sub chambers 30"a, 30"b of the first chamber 30"through the respective opening 36'a, 36'b, in particular each opening, may be provided for each of the openings in a further embodiment, which can be combined with other embodiments described herein. Further, the openings 36"a, 36"b may not only arranged in a side wall 39" of the first chamber 30", but also in the bottom wall 38". With the embodiment of the first chamber 30" shown in Fig. 3, the discharge through the nozzle 32" may be controlled accurately along the length L. In further embodiments, which may be combined with other embodiments, the first chamber 30" may not only include two, but also three or more sub chambers that may be controllable independent from each other, e.g. by a valve at each opening or supply channel for evaporated melamine.

Fig. 4 shows a further embodiment of the first chamber 30"'. The first chamber 30'" has a nozzle 32"' that is arranged below or opposite the drum 20 transporting the substrate 22 to be coated. The first chamber has a bottom wall 38''' opposite the nozzle 32''' and side walls 39'''. An opening 36''' is arranged on the bottom wall''' of the first chamber 30"', in particular in the middle of the bottom wall 39''' of the first chamber 30'''. The middle of the bottom wall 39''' may be defined with respect to the length L of the nozzle 32''', in particular of the length of the slit opening of the nozzle 32'''. The opening 36''' is in fluidal connection with the channel 50 and, therefore, with the second chamber 40. With such a first chamber 30', the uniformity of the melamine deposition on the web or substrate 22 may be enhanced. In a further embodiment, the first chamber 30''' may include two or more openings in the bottom wall 38''', in particular, regularly spaced openings arranged in the longitudinal direction of the first chamber 30''', i.e. parallel to the length L of the nozzle 32'''.

With the embodiments of the second chamber it is possible to provide a substantial homogeneous heat distribution and flow of evaporated melamine along the length L of the nozzle.

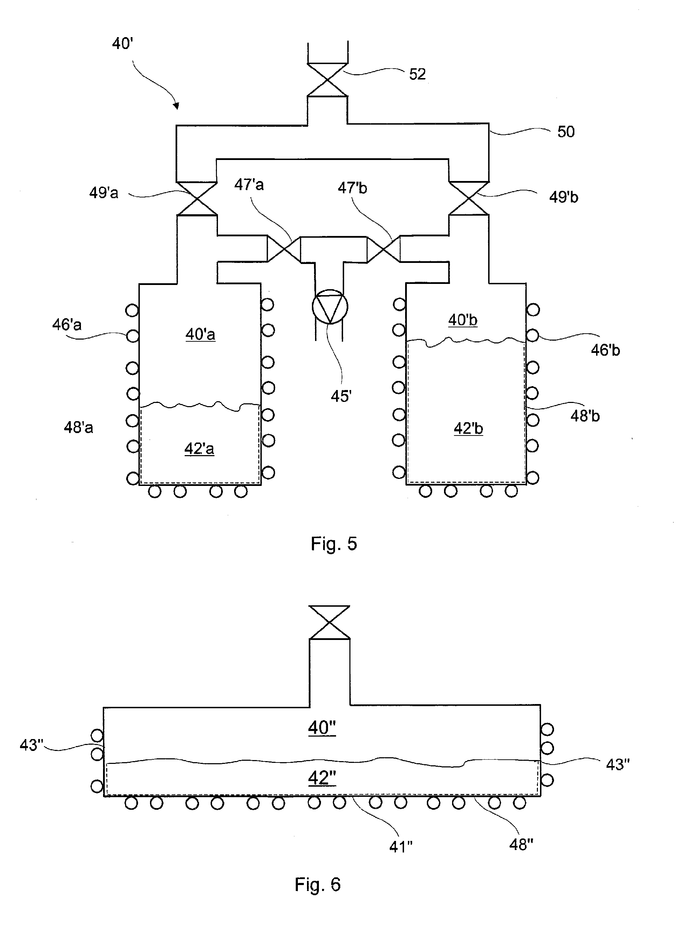

In the following, several embodiments of the second chamber are explained with reference to the drawings of Figs. 5, 6 and 7. These embodiments may be used as alternative or additional modifications of the vaporizer assemblies described herein.

Fig. 5 shows a further embodiment of at last one second chamber 40'. The second chamber 40' includes two or more chambers 40'a and 40'b. Each chamber 40'a and 40'b may be separately heated and controlled by heating devices 46'a and 46'b. Further, in operation of the second chambers 40', each chamber 40'a, 40'b may contain a different amount of melamine 42'a, 42'b. The chambers 40'a and 40'b have sublimation surfaces 48'a, 48'b, respectively, that depend on the quantity of melamine in the chambers 40'a, 40'b. In the example shown in Fig. 5, the first chamber 40'a has a lower sublimation surface than the second chamber 40'b. The evaporated melamine passes through connection valves 49'a, 49'b into the common channel 50. Each valve 49'a, 49'b can be separately opened or closed, in particular in one embodiment which may be combined with other embodiments controlled by the controller 60. If both connection valves 49'a, 49'b are at least partially opened, each chamber 40'a, 40'b provides, at least partially, its sublimation surface 48'a, 48'b to a common, i.e. the combined sublimation surface of the second chamber 40'.

Generally, when referring to combined surfaces as mentioned herein, reference is made to the sum of the areas of the surfaces. Accordingly, a combined surface can be understood as a combined surface area.

In the case that only one valve of the connection valves 49'a, 49'b is opened, and the other valve is closed, only the sublimation surface 48'a, 48'b of one of the chambers 40'a, 40'b which is allocated to the opened valve contributes to the sublimation surface of the second chamber 40'. For example, each of the chambers 40'a, 40'b are adapted to have a sublimation surface of more than 70 percent of the corresponding sublimation surface of the first chamber 30. In a further embodiment, each of the chambers 40'a, 40'b are adapted to have a sublimation surface of more than 90 percent of the corresponding sublimation surface of the first chamber 30. In a typical embodiment, each of the chambers 40'a, 40'b are adapted to have a sublimation exceeding the corresponding sublimation surface of the first chamber 30. Further, in one embodiment, which may be combined with other embodiments, each chamber 40'a, 40'b may be evacuated to the same pressure as in the housing 10 by a pump 45'. The pump is in fluidal connection to the chambers 40'a and 40'b via pump valves 47'a, 47'b allocated to the chambers 40'a, 40'b, respectively.

According to some embodiments, which can be combined with other embodiments described herein, during the coating process of a substrate 22, at least one of the chambers may be refilled via a refill opening (not shown) without stopping the coating process. For example, in the case that the first chamber 40'a should be refilled, the first connection valve 49'a allocated to the first chamber 40'a is closed. The second pump valve 47'b allocated to the second chamber 40'a, which is still producing sublimated melamine for the first chamber 30 remains closed. Then, the first chamber 40'a is filled with melamine 42'a. Subsequently, the first pump valve 47'a allocated to the first chamber 40'a is opened and the pump evacuates the first chamber 40'a of the one or more second chambers 40' to the same pressure, in particular 10⁻² mbar, as in the housing 10. Then, the first connecting valve 49'a is opened again, and the sublimated melamine of chamber 40'a contributes to the coating of the substrate 22. Thus, the web can be continuously coated, even if one of the second chambers 40a' or 40b' has to be refilled with melamine. Further, the pressure in the housing 10 is unchanged during the refill operation. According to some embodiments, which can be combined with other embodiments described herein, the common, i.e. the combined sublimation surface of the second chamber 40' remains substantially constant during the process of refilling of one of the at least one second chambers 40'a, 40'b.

The channel 50 includes the valve 52, as also shown in Fig. 1, for regulating the flow of the evaporated melamine to the first chamber 30. Each valve 47'a, 47'b, 49a', 49b', 52 and the pump 45' are controlled by the controller 60 for providing accurate control of the flow of evaporated melamine to the first chamber 30 and, therefore, a homogeneous coating of the substrate 22 as a function of the time and the location.

In Fig. 6, another embodiment of a second chamber 40" is disclosed, which may combined with other embodiments described herein. The second chamber 40" has a large bottom surface 41" and at least one substantially vertical arranged side surface 43". The bottom surface 41" has at least the same surface than the lateral surfaces 43". Therefore, if the second chamber 40" is filled with the melamine 42" to the middle of the side or lateral surfaces 43", the major part of the sublimation surface 48" is provided by the bottom surface 41". Thus, a variation of the fill height of the melamine in the second chamber 40", e.g. due to sublimation of the melamine, does not lead to a strong variation of the sublimation rate of the melamine 42" in the second chamber 40". Therefore, the embodiment of the second chamber 40" shown in Fig. 6 can provide better control of the thickness of the coating on the substrate 22.

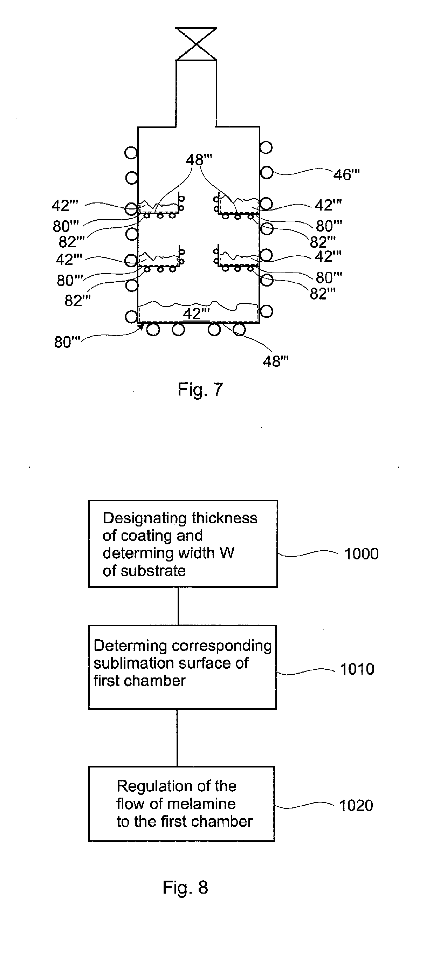

Fig. 7 shows a further embodiment of a second chamber 40"', which may be combined with other embodiments described herein. The second chamber 40''' includes several vats 80''' that are arranged in the second chamber 40'''. The vats are adapted to contain melamine 42''' to be sublimated. Each vat 80''' may contain a different quantity of melamine to be evaporated. In particular, the quantity of melamine to be evaporated may depend on the position of the vat 80''' in the second chamber 40'''. The vats 80''' are separately heated by heating devices 82"'. Further, the second chamber 40''' includes in one embodiment, which may be combined with other embodiments, on the outer surface of its wall 44"', further heating devices 46''' such that the sublimated melamine does not instantly desublimate on the walls 44 of the second chamber. Heating sensors (not shown) may be arranged in the second chamber 40''' or the vats 80''' to control the evaporation rate of each vat 80''' separately. Further, the second chamber 40''' may include several openings (not shown) for refilling melamine in each vat separately.

In the following, a method for controlling the evaporation system is described, as shown in Fig. 8, with respect to the vaporizer assembly of Fig. 1. The method may be also used with other embodiments of the evaporation system. For example, the first and second chambers disclosed in Figs. 2 to 7 may be used in the following method or process. In a first step 1000, the thickness of the coating on the substrate 22 is designated and the width W of the substrate is determined. Depending on the thickness and the width W, the corresponding sublimation surface of the first chamber is calculated and/or the deposition rate on the substrate is determined in a further step 1010. In the last step, the flow of sublimated melamine through the channel 50 to the first chamber 30 is regulated by the valve 52 and/or by a temperature regulation of heating devices 46 (step 1020). In a further embodiment, a closed loop control may be provided using the sensor 70 for determing the thickness of the deposited melamine on the substrate 22.

Typically, the heating devices 34, 46, 54 are arranged in contact with the channel, the first chamber or the second chamber, respectively, such that they form contact heating devices.

Thus, with the controller, a closed loop control of the evaporation and coating process may be provided using the sensor. Further, the first chamber may not only be provided with one opening for this apply with evaporated melamine to the first chamber, but one or more conduits may be provided, for example from each side, from several sides, into several chambers of the nozzle tube or the first chamber, if the first chamber is divided into several sub-chambers. In this case, each conduit, likes the channel, may be provided with separate regulating means for regulating the flow of evaporated melamine to the first chamber or in each sub-chamber of the first chamber. If the second chambers or evaporator chambers are arranged in atmospheric pressure, the second chamber is adapted to resist large pressure differences to the atmospheric pressure, i.e. it may have an internal pressure corresponding to the internal pressure of the housing, e.g. a vacuum chamber, in particular, of 10⁻² mbar. According to some embodiments, which can be combined with other embodiments described herein, the pressure inside the housing may be at about 5⁻³ mbar to 1⁻².

The second chamber, in particular the one or more chambers of the second chamber, may be in some embodiments, which may be combined with other embodiments evacuated by a separated pump or by a bypass to the vacuum chamber or the housing. Thus, the film thickness of the coated web or substrate is controllable to about +/-10%, in particular about +/- 5%. In particular, with the above-disclosed embodiments, it is possible to scale up the length of the nozzle to more than 3 m. Further, the temperature may be controlled in one embodiment, which can be combined with other embodiments at about +/- 50 °C, in particular +/- 5 °C or below with a closed loop temperature control.

Typically, the valves described herein with respect to the embodiments may be adapted to provide a continuous range of positions between a complete open position and a closed position.

In light of the above, embodiments described herein, provide an improved evaporator for organic materials and an improved method for evaporating organic materials. This applies, in particular, for organic materials having a small available evaporation temperature range, such as melamine or the like. Thereby, at least one of the following aspects: the uniformity of the evaporation - in axial and/or cross-sectional direction - by improving heating uniformity, the condensation of material on the nozzle and the shutter, and the uniformity and adhesion on the flexible substrate can be improved.

Accordingly, a plurality of embodiments may include the above details and aspects. For example, an evaporator for vaporizing organic material is provided. In a typical embodiment, the organic material is melamine. The evaporator includes a first chamber having a nozzle adapted to be directed to a substrate to be coated; at least one second chamber for vaporizing the organic material; at least one vapour channel for guiding vaporized organic material from the at least one second chamber to the first chamber; wherein the first chamber is adapted to provide vaporized organic material to the nozzle corresponding to a first virtual sublimation surface, and the at least one second chamber being adapted to provide during operation a combined second sublimation surface area, wherein the combined second sublimation surface area corresponds to at least 70 percent of the first virtual sublimation surface. According to further embodiments, the second sublimation surface area corresponds to at least 90 percent, in particular 95 percent of the first virtual sublimation surface. According to further modifications of these embodiments, the nozzle has a longitudinal axis and a length L in the longitudinal axis between about 1000 mm and about 3500 mm, in particular between about 2000 and about 3000 mm. Thereby, the first virtual sublimation surface is provided by a first dimension with a length of about 170 mm and a second dimension with the same length as the nozzle.

According to further modifications of these embodiments, a sublimation surface is the surface of one of the first or second chamber covered by organic material to be evaporated and heated by a heating device such that the organic material evaporates from that surface. According to further embodiments a valve is arranged in the channel for regulating the flow of evaporated organic material from the second chamber to the first chamber. Thereby, the valve may in one embodiment be a butterfly valve.

According to further embodiments, the evaporator includes a controller adapted to control the flow of the evaporated organic material from the at least one second chamber to the first chamber. Thereby, the controller may be adapted to control the flow dependent on a desired coating thickness, the width of the substrate and/or the length of the opening of the nozzle.

According to further embodiments, at least one heater is arranged at one device selected from the group consisting of vapour channel, the first chamber, valve, and a combination thereof, for heating the device to substantially the sublimation temperature.

According to yet other embodiments, the first chamber includes at least two sub-chambers separated from each other, wherein each sub-chamber of the first chamber is in fluidal connection with the second chamber. Thereby, the evaporator may includes valves for regulating the flow of evaporated organic material to each sub-chamber of the first chamber separately.

According to further embodiments, the at least one second chamber includes at least two chambers separated from each other, wherein each chamber of the at least one second chamber is in fluidal connection with the first chamber. Thereby, each chamber of the at least one second chamber may have a sublimation surface corresponding to at least 70 percent of the first virtual sublimation surface, in particular to at least 90 percent of the first virtual sublimation surface.

According to yet another embodiment, the evaporator may further include at least one valve for regulating the flow of evaporated organic material from each chamber of the at least one second chamber to the first chamber separately.

According to further modifications of these embodiments, the first chamber and the nozzle are disposed in a housing with a sub-atmospheric pressure and the second chamber is disposed outside the housing.

In yet another embodiments, the nozzle has a longitudinal axis and a length L in the longitudinal axis between about 1000 mm and about 3500 mm, in particular between about 2000 and about 3000 mm.

According to another embodiment a method for coating a substrate with organic material with an evaporator having a first chamber and a second chamber is provided. In a typical embodiment, the organic material is melamine. The method includes sublimating the organic material in a second chamber having a during operation a second sublimation surface area; guiding the sublimated organic material from the second chamber to the first chamber, the first chamber having a nozzle directed to the substrate to deposit the sublimated organic material on the substrate, wherein the first chamber is adapted to provide vaporized organic material to the nozzle corresponding to a first virtual sublimation surface, wherein the second sublimation surface area corresponds to at least 70 percent of the first virtual sublimation surface. Thereby, the flow of organic material from the second chamber to the first chamber is controlled in dependence of at least one parameter selected of the group consisting of a desired coating thickness, the width of the substrate, the length of the opening of the nozzle, and a combination thereof. In a further embodiment, the flow of organic material from the second chamber to the first chamber is approximately constant.

According to yet another embodiment, the flow of organic material is controlled by regulating a valve arranged in a channel for guiding the sublimated organic material from the second chamber to the first chamber or by regulating the temperature of heating devices for sublimating the organic material at the second chamber, or a combination thereof.

In a further embodiment, the temperature is regulated with a precision of about 5 °C around a predetermined sublimation temperature value.

According to one embodiment, which may be combined with other embodiments, the flow of organic material is controlled by regulating the sublimation surface of the second chamber. Thereby, the at least one second chamber includes at least two chambers, wherein each chamber has a sublimation surface that, at least partially, constitutes the sublimation surface of the second chamber, wherein the sublimation surface of the second chamber is controlled by regulating valves assigned to each chamber of the at least one second chamber, the valves being arranged in a channel for guiding the sublimated organic material from the second chamber to the first chamber.

According to yet further embodiments, the second sublimation surface area corresponds to at least 90 percent, in particular 95 percent of the first virtual sublimation surface.

According to another embodiment an evaporator for vaporizing melamine is provided including a first chamber having a nozzle adapted to be directed to a substrate to be coated; at least one second chamber for vaporizing the melamine; at least one vapour channel for guiding vaporized melamine from the at least one second chamber to the first chamber; wherein and one or more chambers of the at least one second chamber being adapted to provide during operation a combined second sublimation surface area of about 0,34m² or more,

While the foregoing is directed to embodiments of the present invention, other and further embodiments of the invention may be devised without departing from the basic scope thereof, and the scope thereof is determined by the claims that follow.

## Claims

1. An evaporator for vaporizing organic materials comprising
a first chamber having a nozzle adapted to be directed to a substrate to be coated;
at least one second chamber for vaporizing the organic material;
at least one vapour channel for guiding vaporized organic material from the at least one second chamber to the first chamber; wherein
the first chamber is adapted to provide vaporized organic material to the nozzle corresponding to a first virtual sublimation surface, and the one or more chambers of the at least one second chamber being adapted to provide during operation a combined second sublimation surface area, wherein the combined second sublimation surface area corresponds to at least 70 percent of the first virtual sublimation surface.

2. The evaporator of claim 1, wherein the second sublimation surface area corresponds to at least 90 percent, in particular 95 percent of the first virtual sublimation surface.

3. The evaporator of claim 1 or 2, wherein the nozzle has a longitudinal axis and a length L in the longitudinal axis between about 1000 mm and about 3500 mm, in particular between about 2000 and about 3000 mm.

4. The evaporator of claim 3, wherein the first virtual sublimation surface is provided by a first dimension with a length of about 170 mm and a second dimension with the same length as the nozzle.

5. The evaporator according to one of the claims 1 to 4, wherein a sublimation surface is the surface of one of the first or second chamber covered by organic material to be evaporated and heated by a heating device such that the organic material evaporates from that surface.

6. The evaporator according to one of the claims 1 to 5, wherein a valve is arranged in the channel for regulating the flow of evaporated organic material from the at least one second chamber to the first chamber.

7. The evaporator according to claim 6 further comprising a controller adapted to control the flow of the evaporated organic material from the at least one second chamber to the first chamber.

8. The evaporator according to one of the claims 1 to 7, wherein at least one heater is arranged at one device selected from the group consisting of vapour channel, the first chamber, valve, and a combination thereof, for heating the device to substantially the sublimation temperature.

9. The evaporator according to one of the claims 1 to 8, wherein the at least one second chamber comprises at least two chambers separated from each other, wherein each chamber of the at least one second chamber is in fluidal connection with the first chamber.

10. The evaporator according to one of the claims 1 to 9, wherein the first chamber and the nozzle are disposed in a housing with a sub-atmospheric pressure and the at least one second chamber is disposed outside the housing.

11. The evaporator according to one of the claims 1 to 10, wherein the nozzle has a longitudinal axis and a length L in the longitudinal axis between about 1000 mm and about 3500 mm, in particular between about 2000 and about 3000 mm.

12. A method for coating a substrate with organic material with an evaporator having a first chamber and at least one second chamber, comprising
sublimating the organic material in the at least one second chamber having a during operation a second sublimation surface area;
guiding the sublimated organic material from the at least one second chamber to the first chamber, the first chamber having a nozzle directed to the substrate to deposit the sublimated organic material on the substrate, wherein the first chamber is adapted to provide vaporized organic material to the nozzle corresponding to a first virtual sublimation surface, wherein the second sublimation surface area corresponds to at least 70 percent of the first virtual sublimation surface.

13. The method according to claim 12, wherein the flow of organic material is controlled by regulating a valve arranged in a channel for guiding the sublimated organic material from the at least one second chamber to the first chamber or by regulating the temperature of heating devices for sublimating the organic material at the at least one second chamber, or a combination thereof.

14. The method according to one of the claims 12 to 13, wherein the flow of organic material is controlled by regulating the sublimation surface of the at least one second chamber.

15. An evaporator for vaporizing melamine comprising
a first chamber having a nozzle adapted to be directed to a substrate to be coated;
at least one second chamber for vaporizing the melamine;
at least one vapour channel for guiding vaporized melamine from the at least one second chamber to the first chamber; wherein
the one or more chambers of the at least one second chamber have a combined sublimation surface area of about 0,34m² or more.

## Amended claims

### Amended claims in accordance with Rule 137(2) EPC.

**1.** An evaporator for vaporizing organic materials comprising
a first chamber (30; 30'; 30"a, 30"b; 30"') having a nozzle (32; 32'; 32"; 32'")adapted to be directed to a substrate to be coated;
at least one second chamber (40; 40'a, 40'b; 40") for vaporizing the organic material; at least one vapour channel (50) for guiding vaporized organic material from the at least one second chamber to the first chamber; wherein
the first chamber is adapted to provide vaporized organic material to the nozzle corresponding to a first virtual sublimation surface which corresponds to a sublimation surface as if the organic material is evaporated in the first chamber, and the one or more chambers of the at least one second chamber being adapted to provide during operation a combined second sublimation surface area, wherein the combined second sublimation surface area corresponds to at least 70 percent of the first virtual sublimation surface.

**2.** The evaporator of claim 1, wherein the second sublimation surface area corresponds to at least 90 percent, in particular 95 percent of the first virtual sublimation surface.

**3.** The evaporator of claim 1 or 2, wherein the nozzle has a longitudinal axis and a length L in the longitudinal axis between about 1000 mm and about 3500 mm, in particular between about 2000 and about 3000 mm.

**4.** The evaporator of claim 3, wherein the first virtual sublimation surface is provided by a first dimension with a length of about 170 mm and a second dimension with the same length as the nozzle.

**5.** The evaporator according to one of the claims 1 to 4, wherein a sublimation surface is the surface of one of the first or second chamber covered by organic material to be evaporated and heated by a heating device such that the organic material evaporates from that surface.

**6.** The evaporator according to one of the claims 1 to 5, wherein a valve is arranged in the channel for regulating the flow of evaporated organic material from the at least one second chamber to the first chamber.

**7.** The evaporator according to claim 6 further comprising a controller adapted to control the flow of the evaporated organic material from the at least one second chamber to the first chamber.

**8.** The evaporator according to one of the claims 1 to 7, wherein at least one heater is arranged at one device selected from the group consisting of vapour channel, the first chamber, valve, and a combination thereof, for heating the device to substantially the sublimation temperature.

**9.** The evaporator according to one of the claims 1 to 8, wherein the at least one second chamber comprises at least two chambers separated from each other, wherein each chamber of the at least one second chamber is in fluidal connection with the first chamber.

**10.** The evaporator according to one of the claims 1 to 9, wherein the first chamber and the nozzle are disposed in a housing with a sub-atmospheric pressure and the at least one second chamber is disposed outside the housing.

**11.** The evaporator according to one of the claims 1 to 10, wherein the nozzle has a longitudinal axis and a length L in the longitudinal axis between about 1000 mm and about 3500 mm, in particular between about 2000 and about 3000 min.

**12.** A method for coating a substrate with organic material with an evaporator having a first chamber and at least one second chamber, comprising
sublimating the organic material in the at least one second chamber having during operation a second sublimation surface area;
guiding the sublimated organic material from the at least one second chamber to the first chamber, the first chamber having a nozzle directed to the substrate to deposit the sublimated organic material on the substrate, wherein the first chamber is adapted to provide vaporized organic material to the nozzle corresponding to a first virtual sublimation surface which corresponds to a sublimation surface as if the organic material is evaporated in the first chamber, wherein the second sublimation surface area corresponds to at least 70 percent of the first virtual sublimation surface.

**13.** The method according to claim 12, wherein the flow of organic material is controlled by regulating a valve arranged in a channel for guiding the sublimated organic material from the at least one second chamber to the first chamber or by regulating the temperature of heating devices for sublimating the organic material at the at least one second chamber, or a combination thereof.

**14.** The method according to one of the claims 12 to 13, wherein the flow of organic material is controlled by regulating the sublimation surface of the at least one second chamber.

**15.** An evaporator for vaporizing melamine comprising
a first chamber having a nozzle adapted to be directed to a substrate to be coated;
at least one second chamber for vaporizing the melamine;
at least one vapour channel for guiding vaporized melamine from the at least one second chamber to the first chamber; wherein
the one or more chambers of the at least one second chamber have a combined sublimation surface area of about 0,34m² or more.
